# EUROPEAN PATENT SPECIFICATION

(11) **EP 0 807 694 B1**
(45) Date of publication and mention of the grant of the patent: **11.12.2002**
(21) Application number: 97107815.9
(22) Date of filing: 13.05.1997
(51) Int. Cl.: C23C 16/44, H01L 21/316

(54) **Deposition chamber and method for low dielectric constant film**
Aufdampfungskammer und Verfahren zur Herstellung eines Films mit einer niedrigen Dielektrizitätskonstante
Chambre de dépôt et méthode pour la production d'un film à faible constante diélectrique

(30) Priority: 13.05.1996 US 647619
(43) Date of publication of application: 19.11.1997
(73) Proprietor: APPLIED MATERIALS, INC., Santa Clara, California 95050 (US)
(72) Inventor: Li, Shijian, San Jose, California 95129 (US); Wang, Yaxin, Fremont, California 95439 (US); Redeker, Fred C., Fremont, California 94539 (US); Ishikawa, Tetsuya, Santa Clara, California 95050 (US); Collins, Alan W., San Francisco, California 94107 (US)
(74) Representative: Kirschner, Klaus Dieter, Dipl.-Phys.

(56) References cited:
- EP-A- 0 599 730
- US-A- 5 304 250
- PATENT ABSTRACTS OF JAPAN vol. 003, no. 135 (E-150), 10 November 1979 & JP 54 111771 A (TOSHIBA CORP), 1 September 1979,

## Description

The invention is directed to a film deposition method and a deposition system for carrying out the method.

One of the primary steps in the fabrication of modern semiconductor devices is the formation of a thin film on a semiconductor substrate by chemical reaction of gases. Such a deposition process is referred to as chemical vapor deposition (CVD). Conventional thermal CVD processes supply reactive gases to the substrate surface where heat-induced chemical reactions can take place to produce the desired film. High density plasma CVD processes promote the disassociation of the reactant gases by the application of radio frequency (RF) energy to the reaction zone proximate the substrate surface thereby creating a plasma of highly reactive species. The high reactivity of the released species reduces the energy required for a chemical reaction to take place, and thus lowers the required temperature for such CVD processes.

In one design of high density plasma chemical vapor deposition (HDP-CVD) chambers, the vacuum chamber is generally defined by a planar substrate support, acting as a cathode, along the bottom, a planar anode along the top, a relatively short sidewall extending upwardly from the bottom, and a dielectric dome connecting the sidewall with the top. Inductive coils are mounted about the dome and are connected to a supply radio frequency generator. The anode and the cathode are typically coupled to bias radio frequency generators. Two or more sets of equally spaced gas distributors, such as nozzles, are typically mounted to the sidewall and extend into the region above the edge of the substrate support surface. The gas nozzles for each set are coupled to a common manifold for that set; the manifolds provide the gas nozzles with process gases, including gases such as argon, oxygen, silane (SiH₄), TEOS (tetraethoxy-silane), silicon tetrafluoride (SiF₄), etc., the composition of the gases depending primarily on the type of material to be formed on the substrate. Sets of gas nozzles are commonly used because some gases, such as silane, need to be delivered into the chamber separately from other gases, such as oxygen; other gases, such as oxygen and SiF₄, can be delivered to a common set of nozzles through a common manifold. The nozzle tips have exits, typically orifices, positioned in a circumferential pattern spaced apart above the circumferential periphery of the substrate support and through which the process gases flow.

As semiconductor devices shrink in size, the capacitance between adjacent conductors increases. This increase in capacitance adversely affects the speed of the devices. To partially alleviate this problem, the dielectric constant of the deposited dielectric film, typically about 4.1 for undoped silicon glass (USG), must be reduced. Recently, fluorine doping with SiF4 chemistry, which results in fluorine-doped silicon glass (FSG), has become popular to reduce the dielectric constant. It is believed that it is possible to produce a dielectric film having good thermal stability with a dielectric constant of 3.5 with FSG. However, this value (3.5) for the dielectric constant has not been readily achievable.

EP-A-0 599 730 discloses a method for forming silicone oxide films having a dielectric constants of 3.7 to 2.9. This document shows a remote plasma system. Argon and oxygen are introduced into a plasma chamber, and from the plasma chamber the argon/O2-plasma is introduced to the deposition chamber, to which silicone tetraflouride is supplied.

Furthermore, US-A-5,304,250 discloses a deposition chamber having a top with a first gas injection manifold having one single connector and a concentric plenum having exits at a plurality of positions spaces apart and equally spaced about the center of the top. A second gas manifold is provided comprising a plurality of nozzles configured to injecting gaseous substance into the chamber. The nozzles are surrounding the substrate at a plurality of position and are located generally above the substrate.

From the WO-A-97/032224 and EP-A-0839217 which is state for art according to Art. 54 (3) EPC with a publication date of January 30, 1997, a filing date of June 21, 1996 and a priority date of July 10, 1995, a plasma enhanced chemical processing reactor and method is known, the reactor including a plasma chamber having a top with a first gas injection manifold, a second gas manifold and a source of electromagnetic energy. The first gas injection manifold having independent connectors and concentric and circumferentially extending plenums each having exits at a plurality of positions spaces apart and equally spaced about the center of the top. The second gas manifold is mounted along the wall of the processing chamber and comprises a nozzle structure which has a plurality of nozzles configured to injecting gaseous substances into the chamber. The gas distributors and exits are surrounding the substrate at a plurality of position and are located generally above the substrate.

It is the object of the present invention to provide a method and a deposition system for depositing uniform films with uniformly low dielectric constants of below 3.5, preferably below 3.4, and more preferably below 3.3.

The above object is achieved by a method for depositing a film onto a substrate within a deposition chamber according to claim 1 and by a deposition system according to claim 11. The dependent claims are related to further advantageous aspects of the present invention.

This is achieved by a the uniform application of the gases (preferably silage, fluorine-supplying gases such as SiF4 or CF4, and oxygen-supplying gases such as O2 or N2O) to the substrate. The result is preferably improved by the selection of optimal flow rates for the gases, which preferably have been determined as a result of tests using the particular chamber.

The improved deposition system according to a preferred embodiment of the invention includes a housing defining a deposition chamber. A substrate support is housed within the deposition chamber. A first gas distributor has orifices or other exits opening into the deposition chamber in a circumferential pattern spaced apart from and generally overlying the circumferential periphery of the substrate support surface. In one embodiment the first gas distributor comprises first and second sets of nozzles. Oxygen and SiF4 are preferably delivered together to the chamber through the first set of nozzles and silane (or silane and SiF4) is delivered through the second set of nozzles. Mixing the SiF4 with oxygen and introducing this combination through the first set of nozzles reduces equipment complexity so cost can be reduced. A second gas distributor, preferably a center nozzle, is used and is positioned spaced apart from and above the substrate support surface. The use of the second gas distributor to inject a gas, preferably silane (or silane and SiF₄), into the vacuum chamber helps to improve the uniform application of the gases to the substrate over that which is achieved without the use of the second gas distributor.

Oxygen-supplying gas (preferably oxygen) is delivered to the chamber through the top of the housing in a region generally above and preferably generally centrally above the substrate. This is preferably achieved by passing the oxygen through an annular orifice created between the center nozzle carrying the silane (and any other gases) and a hole in the top of the housing. In this way, oxygen is provided both from the sides through the first set of nozzles of the first gas distributors, preferably mixed with SiF₄, and also in the same region as silane above the substrate. Also, the passage of the oxygen through the annular orifice keeps reactive gases within the chamber from attacking the seals used between the top of the housing and the body from which the center nozzle extends. This advantage is retained if silane is passed through the annular orifice and oxygen through the center nozzle.

Film thickness and dielectric constant uniformity is also enhanced by insuring that the temperature of the substrate remains uniform across the substrate and using a source RF generator designed to achieve sputtering uniformity.

One of the primary aspects of the invention is the recognition that it is very important to ensure the uniform distribution of oxygen entering the chamber. This is achieved by flowing oxygen both from the top of the chamber and from the sides of the chamber. Additionally, by the appropriate configuration of the oxygen flow path through the top of the chamber, the oxygen can serve to protect the sealing element from deleterious effects of coming in contact with reactive gases such as fluorine.

In addition to the need to supply the gases to the substrate uniformly, it is preferable to use the appropriate proportion of the gases, typically oxygen, silane and SiF₄, to achieve the minimum dielectric constant. The proper flow rates for each will differ according to the particular chamber used. Accordingly, it is a preferred aspect of the invention to test a variety of flow rate proportions to determine which set of flow rates provides a high quality dielectric film with a minimum dielectric constant.

Further preferred embodiments of the invention and the features thereof are given in the appended claims and subclaims.

Preferred embodiments of the invention will now be described in detail in conjunction with the accompanying drawings in which
Fig. 1 is a schematic cross-sectional view showing a deposition chamber made according to one embodiment of the invention;
Fig. 2 is an exaggerated view illustrating the characteristic M-shaped, deposition thickness variation plot of the prior art;
Fig. 3 illustrates an improvement in the deposition thickness variation plot of Fig. 2 using the apparatus of Fig. 1;
Fig. 4 is a graph of dielectric constant versus oxygen flow for different flow rate ratios of SiF₄ to silane;
Fig. 5 is a simplified view of an alternative embodiment of the center nozzle of Fig. 1 having three orifices; and
Fig. 6 is a view in the region of the center nozzle showing additional oxygen passageways.

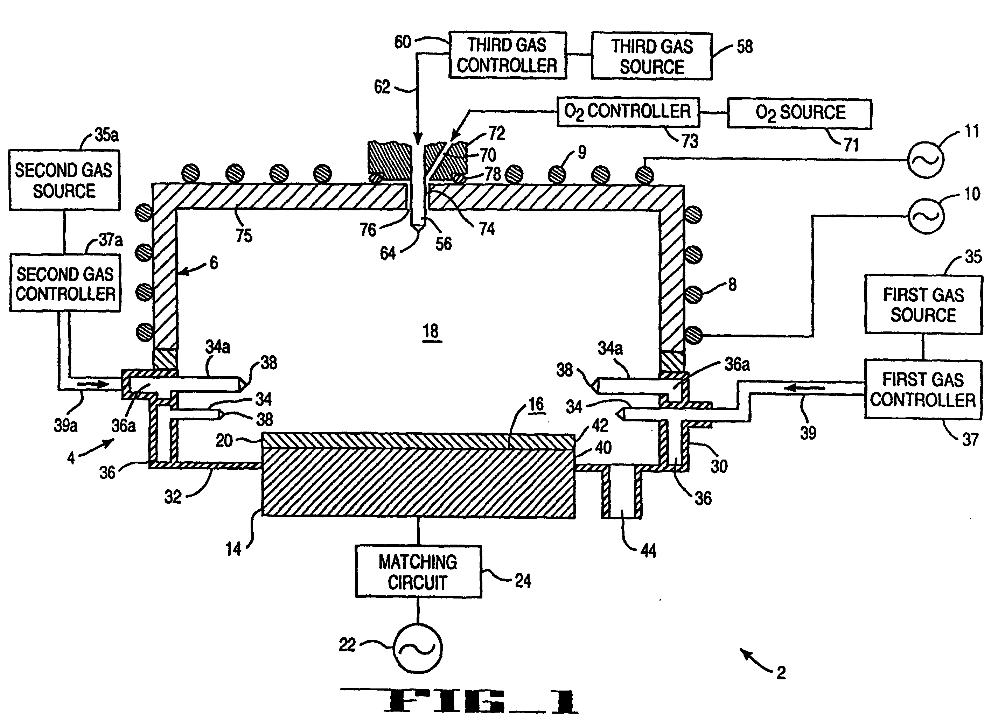

Fig. 1 illustrates a deposition chamber 2 comprising a housing 4, the housing including a generally cylindrized dielectric enclosure 6 surrounded by two sets of RF inductive coils 8, 9. Enclosure 6 could be made of RF transparent materials other than a dielectric material. Coils 8, 9 are powered by a pair of source RF generators 10, 11. Chamber 2 also includes a water-cooled substrate support 14 having a substrate support surface 16 within the vacuum chamber 18 defined within housing 4. Surface 16 is used to support a substrate 20 within chamber 18. Substrate support 14 acts as a cathode and is connected to a bias RF generator 22 through a matching circuit 24. A generally cylindrical sidewall 30 of housing 4 connects the bottom 32 of housing 4 to dielectric enclosure 6. Sidewall 30 acts as the anode.

Process gases are introduced to vacuum chamber 18 in the region surrounding substrate 20 through two sets of 12 equally spaced nozzles 34, 34a. Nozzles 34, 34a are arranged in a ring-like pattern and are fluidly coupled to gas manifolds 36, 36a, respectively. Manifolds 36, 36a are fed process gases from first and second gas sources 35, 35a through first and second gas controllers 37, 37a and first and second gas feed lines 39, 39a. Each nozzle 34, 34a has an orifice 38 at its distal end. The orifices 38 of nozzles 34, 34a are arranged above the periphery 40 of substrate support 14 and thus above the periphery 42 of substrate 20. Vacuum chamber 18 is exhausted through an exhaust port 44.

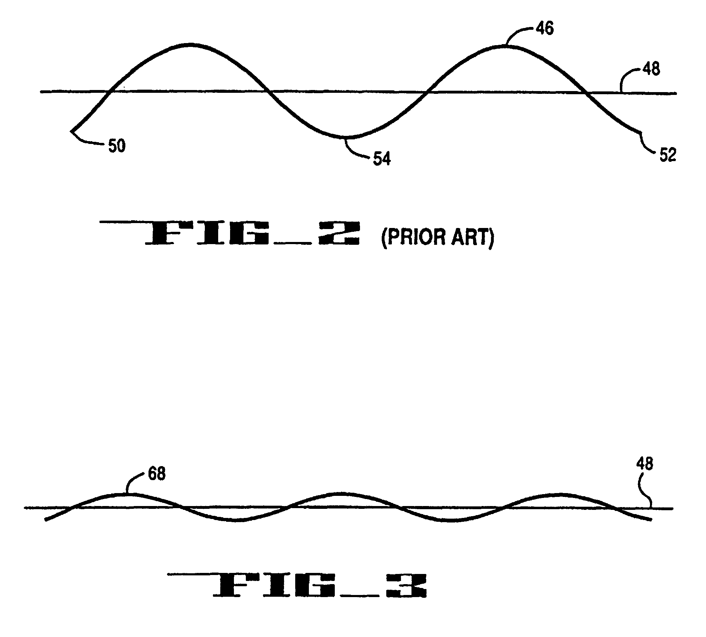

Fig. 2 illustrates a typical USG deposition thickness variation plot 46 for a conventional deposition chamber. The average thickness is shown by base line 48. As can be seen by plot 46, there is a relatively steep increase in thickness at end points 50 and 52 of plot 46 corresponding to the periphery 42 of substrate 20. The center 54 of plot 46 also dips down substantially as well.

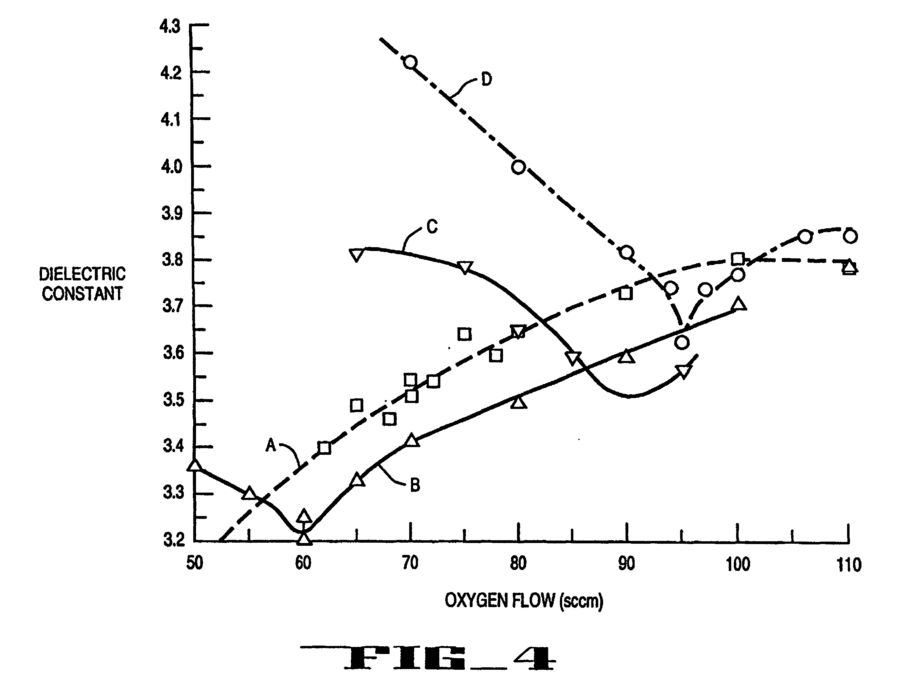

Plot 46 can be improved through the use of a center nozzle 56 coupled to a third gas source 58 through a third gas controller 60 and a third gas feed line 62. Center nozzle 56 has an orifice 64 positioned centrally above substrate support surface 16. Using center nozzle 56 permits the modification of USG deposition thickness variation plot 46 from that of Fig. 2 to exemplary plot 68 of Fig. 3. Exemplary deposition thickness variation plot 68 is flat enough so that the standard deviation of the deposition thickness can be about 1 to 2% of one sigma. This is achieved primarily by reducing the steep slope of the plot at end points 50, 52 and raising in the low point at center 54 of plot 46.

The various components of chamber 2 are controlled by a processor (not shown). The processor operates under control of a computer program stored in a computer-readable medium (also not shown). The computer program dictates the various operating parameters, such as timing, mixture of gases, chamber pressure, substrate support temperature and RF power levels.

The embodiments of the present invention improve upon the above-described structure in a manner which results in films having dielectric constants of less than 3.5 and preferably less than 3.4 and more preferably less than 3.3; these low dielectric constant values are achieved in a generally uniform manner over substrate 20. The uniform reduction of the dielectric constant is important because as device sizes are reduced, capacitance between closely spaced conductors will naturally increase. To reduce the capacitance, and thus speed up operation of the devices, the dielectric constant of the deposited dielectric film must be reduced.

In the embodiments of the present invention preferably a combination of SiF₄ and oxygen from first gas source 35 for introduction into chamber 18 is supplied through orifices 38 of nozzles 34. Doing so simplifies the delivery of these gases and helps reduce cost. Silane (SiH₄) is preferably delivered into chamber 18 from second gas source 35a, through second gas controller 37a, and through nozzles 34a. In addition, third gas source 58 is preferably used to introduce silane (or, for example, a mixture of silane and SiF₄) into chamber 18 from above substrate 20. In conjunction with this, oxygen is also directed into chamber 18 from a position above substrate 20 but along a flow path separate from the flow path of the silane.

Oxygen can be mixed with a relatively stable gas such as SiF₄; however, due to the reactive nature of silane and oxygen, these components must be kept separate until their introduction into chamber 18. To accomplish this, separate nozzles 34, 34a are used in the region around substrate support 14; also an oxygen pathway 70 is formed in a body 72 mounted to the top 75 of enclosure 6. Pathway 70 is coupled to an oxygen source 71 through an oxygen controller 73. Third gas line 62 passes through body 72 and terminates at center nozzle 56. Center nozzle 56 passes through an opening 74 formed in top 75. Nozzle 56 and opening 74 provide an annular orifice 76 in fluid communication with vacuum chamber 18 and oxygen pathway 70. A fluid seal 78 is provided between body 72 and top 75. Oxygen thus proceeds through pathway 70, into a region defined between body 72 and top 75 and bounded by fluid seal 78, and finally along annular orifice 76. By injecting oxygen in this way, gases, such as fluorine compounds, which could otherwise have a deleterious effect on fluid seal 78, are prevented from reaching the fluid seal by the washing effect or scouring effect of the flowing oxygen. Gases other than oxygen which do not cause seal 78 to deteriorate can also be used.

In conjunction with the uniformity of gas distribution using the structure discussed above, uniform dielectric constants are also dependent upon temperature uniformity across substrate 20 and sputtering uniformity. Varying the total flow of SiF₄ and silane affects deposition rate and thus throughput. High throughput requires high bias power from bias power source 22 to create high sputtering and high etching rates. High bias power, and thus high throughput, is possible only if temperature uniformity across substrate 20 is achieved since speed of etching is strongly affected by the temperature of the substrate.

The determination of the amounts of SiF₄, silane (SiH₄) and oxygen to be used creates an entire new layer of complexity. Assuming the total flow rate of silicon (e.g., from SiH₄ and SiF₄) remains constant, it is believed that several basic statements can be made regarding the use of these various components. If too little oxygen is used, the deposition rate drops dramatically thus making the process much too inefficient. Too little oxygen can leave the film silicon rich with excess free fluorine incorporated into the film. If too much oxygen is used, the resulting film becomes more USG and the dielectric constant becomes high. If too much SiF₄ is used, aging problems can result; aging problems result because over time the fluorine, which is not bound tightly in the complex chemistry of the resulting film, gets released causing deterioration of the device. Too much silane will cause the film to behave more like USG and thus result in a dielectric constant at an undesirable level.

The optimal amounts of oxygen, SiF₄ and silane at the substrate surface are the stoichiometric proportions. However, flowing stoichiometric proportions of the gases into deposition chambers, including chamber 2 and other deposition chambers, would result in gas proportions at the substrate surface which are not the stoichiometric proportions. The actual proportions of the gas flowing into the deposition chamber needed to achieve stoichiometric proportions at the substrate surface will vary from the stoichiometric proportions at least in part according to the structure of the specific chamber. The more efficient the chamber, the less gas is wasted so that gas flow rates closer to the stoichiometric amounts can be used.

To determine the proper relative flow rates of SiF₄, silane and oxygen for a particular chamber to achieve the desirable dielectric constant below 3.5, preferably below 3.4 and more preferably below 3.3, the proportions of the three components could be varied in any desired manner to create a number of dielectric films on substrates 20; the dielectric constant at different positions along each dielectric film could then be measured. However, some limits in the relative amounts are in order. The percentage of SiF₄ should be between about 40% to 60% of the total silicon-supplying gas to reduce or eliminate the problems resulting from too much or too little SiF₄ and silane. Oxygen should be between about 60% to 100% of the total silicon-supplying gas.

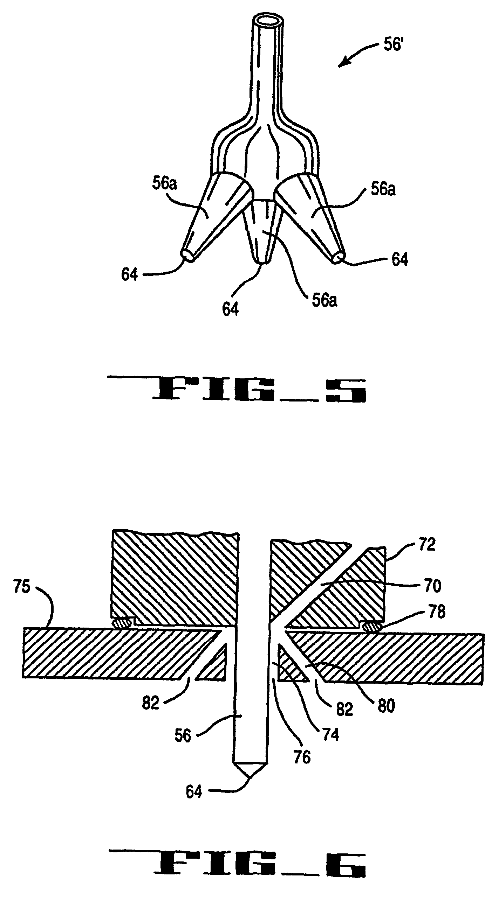

Fig. 4 illustrates the results of a set of tests conducted varying the ratios of SiF₄ to silane to oxygen. It was found that by selecting a total reactive gas flow rate, that is a flow rate for the combination of SiF₄ and silane (which results in a constant amount of silicon), dividing that total between SiF₄ and silane to arrive at various proportions of SiF₄ and silane, and then, using those proportions, varying the oxygen flow, the graph shown in Fig. 4 of dielectric constant to oxygen flow was created. This type of graph provides very useful data.

Plot A, resulting from 44 sccm SiF₄ to 36.4 sccm silane, results in a dielectric constant which varies from 3.4 at an oxygen flow of about 62 sccm to about 3.8 at an oxygen flow rate of about 110 sccm. It is not clear from this graph where the minimum dielectric constant would be for this ratio of SiF₄ to silane. It appears, however, that the minimum would occur at an unacceptably low oxygen flow rate. Plot B, having an sccm flow rate ratio of SiF₄ to silane of 36 to 44.4 provides the lowest dielectric constant: about 3.2 at an oxygen flow of 60 sccm. Plots C and D have minimum dielectric constants of about 3.5 and 3.6 respectively. From this graph it is clear that for these particular ratios of SiF₄ to silane, the ratio for plot B provides the lowest dielectric constant with oxygen flow being at an acceptable level. Reviewing plots A and B suggests that a proportion of SiF₄ to silane between the proportions for these two plots may yield a lower dielectric constant than achievable with the proportion for plot B.

Accordingly, the embodiments of the present invention provide a useful and efficient way of determining how to achieve films with low dielectric constants using SiF₄ (or another fluorine-supplying gas) and silane chemistry to achieve the reduced dielectric constants. While the above-described method of choosing a single total reactive gas flow rate for each of the tests is presently preferred, other methods for the orderly gathering of dielectric constant information may also be pursued. For example, it may be desired to allow all three variables to change within the overall parameters.

In use, a film having a low dielectric constant can be deposited on substrate 20 by first determining the appropriate flow rates of SiF₄, silane and oxygen, typically in the manner discussed above by plotting the results of different tests. Once the desired rate for the particular chamber has been determined, silane is introduced into chamber 18 from second gas source 35a, a mixture of silane and SiF₄ is introduced into chamber 18 from third gas source 58, oxygen is introduced into the chamber from oxygen source 71, and a mixture of oxygen and SiF₄ is introduced into chamber 18 from first gas source 35. Argon is also introduced from first and third sources 35, 58. Deposition uniformity is also aided by insuring that the temperature of substrate 20 is uniformly controlled over its surface and by the use of a variable frequency source RF generators 10, 11 to help achieve uniform sputtering.

The above-described embodiment has been designed for substrates 20 having diameters of 8 inches (20 cm). Larger diameter substrates, such as substrates having diameters of 12 inches (30 cm), may call for the use of multiple center nozzles 56a as illustrated in Fig. 5 by the nozzle assembly 56'. In such embodiments the deposition thickness variation plot would likely have a three-bump (as in Fig. 3), a four-bump or a five-bump shape. The particular shape for the deposition thickness plot would be influenced by the type, number, orientation and spacing of center nozzles 56A and orifices 64.

In addition to orifice 76, oxygen may also be directed into chamber 18 through a number of downwardly and outwardly extending passageways 80 as shown in Fig. 6. Each passageway 80 has an orifice 82 where oxygen enters into chamber 18. If desired, other gases, such as argon, may be mixed with one or both of the silane passing through orifice 64 or oxygen passing through annular orifice 76 or orifices 82.

## Claims

1. Method for depositing a film onto a substrate (20) within a deposition chamber (2) having a housing with a top (75) the method comprising the steps of:
injecting at least a first process gas into the chamber (2) at a plurality of positions (34) surrounding a substrate (20) within the chamber (2);
injecting a second process gas into the chamber (2) from a center nozzle in a position in the center of the top (75) which position is spaced apart from and located centrally above the substrate (20); and
injecting a third process gas into the chamber (2) from an annular orifice surrounding the center nozzle in a position in the center of the top (75) which position is spaced apart from and located centrally above the substrate (20),
wherein said third process gas injecting step is carried out in a manner such that said third process gas and said second process gas do not mix until they are within said chamber, and wherein said second process gas or said third process gas comprises silane and said third process gas or said second process gas comprises an oxygen-supplying gas respectively.

2. Method according to claim 1, wherein the first process gas injecting step is carried out using an oxygen-supplying gas, preferably oxygen, as the first process gas and a fluorine-supplying gas, preferably silicon tetrafluoride, as a further process gas.

3. Method according to claim 1, wherein said first process gas injecting step is carried out by injecting at least silane as the first process gas separately from said oxygen-supplying gas as a further process gas.

4. Method according to claim 1, wherein the second process gas injecting step is carried out using at least silane.

5. Method according to claim 1, wherein the first and second process gas injecting steps are carried out using a fluorine-supplying gas and silane.

6. Method according to claim 1, wherein the first and second process gas injecting steps are carried out using gases having different compositions.

7. Method according to claim 1, wherein the third process gas injecting step is carried out using an oxygen-supplying gas, preferably oxygen.

8. Method according to claim 1, wherein the second process gas injecting step is carried out using at least silane and silicon tetrafluoride, and wherein the flow rates of silicon tetrafluoride and silane are selected at about 36 and 44 sccm respectively and a total oxygen flow rate of less than 80 sccm is selected.

9. Method according to claim 5, wherein a graph is created plotting dielectric constant versus oxygen-supplying gas flow rate for each said set of silane and fluorine-supplying gas flow rates, and wherein the desired set of flow rates is selected based upon the minimum dielectric constant of said graphs.

10. Method according to any of the claims 1 to 8, wherein the three injecting steps occur simultaneously.

11. Deposition system for carrying out a method according to any of the claims 1 to 10, comprising:
a housing (4) having a top (75) defining a chamber (2);
a substrate support (14) within the chamber (2);
a first gas distributor (34) having first orifices (38) opening into the chamber (2) at locations around a substrate support surface (16);
a second gas distributor (56) comprising a center nozzle (56) located at a position in the center of the top (75) which position is spaced apart from and located centrally above the substrate (20); and
a third process gas distributor (70) comprising an annular orifice (76) surrounding said center nozzle (56) located at a position in the center of the top (75) which position is spaced apart from and located centrally above the substrate (20);
wherein said first, second and third process gas distributors (34, 56, 70) are connected to first, second and third process gas sources (35, 58, 71) which are separate from each other.

12. Deposition system according to claim 11, wherein first orifices (38) of the first gas distributor (34) are equally spaced about the center of the substrate (20).

13. Deposition system according to claim 11 or 12, wherein said first gas distributor (34) comprises first and second sets of nozzles (34, 34a), said first set of nozzles being fluidly isolated from said second set of nozzles.

14. Deposition system according to claim 11, wherein the center nozzle (56) comprising a plurality of second orifices (64) and the third gas distributor (70) comprising a plurality of third orifices (82) which are located at spread-out positions at the position in the center of the top (75) which position is spaced apart from and located centrally above the substrate (20).

15. Deposition system according to claim 11, wherein said housing (4) comprises a top, said top defines an access opening (74) therethrough; said center nozzle (56) passes through said access opening (74); and said third gas distributor (70) comprises a pathway (76) defined in part by a fluid seal (78), captured between a body (70) and said top (75), circumscribing said access opening (74).

16. Deposition system according to claim 15, wherein said pathway comprises a plurality of outwardly and downwardly extending path portions (84) spaced apart from said nozzle (56) and defining additional orifices (82) of the third gas distributor (70).

17. Deposition system according to claim 11, wherein said housing (4) comprises a dielectric enclosure, said dielectric enclosure comprising said top (75), and wherein inductive coils (8) are mounted to the housing (4) and coupled to a radio frequency generator (10, 11).

## Patentansprüche

1. Verfahren zum Aufdampfen eines Films auf ein Substrat (20) in einer Aufdampferkammer (2) mit einem Gehäuse mit einem Oberteil (75), wobei das Verfahren die folgenden Schritte aufweist:
Zuführen von wenigstens einem ersten Prozessgas in die Kammer (2) an einer Vielzahl von Positionen (34), die ein Substrat (20) in der Kammer (2) umgeben;
Zuführen eines zweiten Prozessgases in die Kammer (2) von einer zentralen Düse in einer Position in der Mitte des Oberteils (75), welche Position unter Abstand von und mittig oberhalb des Substrates (20) liegt; und
Zuführen eines dritten Prozessgases in die Kammer (2) von einer ringförmigen Öffnung, die die zentrale Düse umgibt, in einer Position in der Mitte des Oberteils (75), welche Position unter Abstand von und mittig oberhalb des Substrats (20) liegt,
wobei der Schritt der Zufuhr des dritten Prozessgases in einer solchen Weise ausgeführt wird, dass sich das dritte Prozessgas und das zweite Prozessgas nicht mischen, bis sie sich in der Kammer befinden, und wobei das zweite Prozessgas oder das dritte Prozessgas Silan und das dritte Prozessgas oder das zweite Prozessgas ein Sauerstoff lieferndes Gas respektive aufweist.

2. Verfahren nach Anspruch 1, worin der Schritt des Zuführens des ersten Prozessgases ausgeführt wird unter Verwendung eines Sauerstoff liefernden Gases, vorzugsweise Sauerstoff, als erstes Prozessgas und eines Fluor liefernden Gases, vorzugsweise Siliciumtetrafluorid, als weiters Prozessgas.

3. Verfahren nach Anspruch 1, worin der Schritt des Zuführens des ersten Prozessgases dadurch durchgeführt wird, dass wenigstens Silan als erstes Prozessgas separat von dem Sauerstoff liefernden Gas als ein weiteres Prozessgas zugeführt wird.

4. Verfahren nach Anspruch 1, worin der Schritt des Zuführens des zweiten Prozessgases unter Verwendung von wenigstens Silan durchgeführt wird.

5. Verfahren nach Anspruch 1, worin die Schritte des Zuführens des ersten und des zweiten Prozessgases unter Verwendung eines Fluor zuführenden Gases und Silan durchgeführt werden.

6. Verfahren nach Anspruch 1, worin die Schritte des Zuführens des ersten und des zweiten Prozessgases unter Verwendung von Gasen mit unterschiedlichen Zusammensetzungen durchgeführt werden.

7. Verfahren nach Anspruch 1, worin der Schritt des Zuführens des dritten Prozessgases unter Verwendung eines Sauerstoff liefernden Gases, vorzugsweise Sauerstoff, durchgeführt wird.

8. Verfahren nach Anspruch 1, worin der Schritt des Zuführens des zweiten Prozessgases unter Verwendung von wenigstens Silan und Silantetrafluorid durchgeführt wird, und worin die Flußrate des Siliciumtetrafluorids und des Silans bei etwa 36 und 44 sccm respektive gewählt werden und eine Gesamtsauerstoffflußrate von weniger als 80 sccm gewählt wird.

9. Verfahren nach Anspruch 5, worin eine grafische Darstellung erzeugt wird, in der die Elektrizitätskonstante gegen die Flußrate des Sauerstoff liefernden Gases für jeden Satz der Silan und Fluorid zuführenden Gasflußraten aufgetragen ist, und wobei der gewünschte Satz von Flußraten auf der Basis der minimalen die Elektrizitätskonstanten der grafischen Darstellungen ausgewählt wird.

10. Verfahren nach einem der Ansprüche 1 bis 8, worin die drei Zuführungsschritte gleichzeitig ablaufen.

11. Aufdampfsystem zur Durchführung eines Verfahrens nach einem der Ansprüche 1 bis 10, umfassend:
- ein Gehäuse (4) mit einem Oberteil (75), dass eine Kammer (2) definiert;
- eine Substrathalterung (14) in der Kammer (2);
- einen ersten Gasverteiler (34) mit einer ersten Mündung (38), die sich in die Kammer anstellen um eine Substrathalterungsoberfläche (16) öffnen;
- einen zweiten Gasverteiler (56), der eine zentrale Düse (56) aufweist, die an einer Position in der Mitte des Oberteils (75) angeordnet ist, welche Position unter Abstand von und mittig oberhalb des Substrats (20) liegt; und
- einen dritten Prozessgasverteiler (70), der eine ringförmige Mündung (76), die die zentrale Düse (56) umgibt, umfasst und an einer Position in der Mitte des Oberteils (75) angeordnet ist, welche Position unter Abstand von und mittig oberhalb des Substrates (20) liegt;
- worin die ersten, zweiten und dritten Prozessgasverteiler (34, 56, 70) mit ersten, zweiten und dritten Prozessgasquellen (35, 58, 71) verbunden sind, die separat voneinander sind.

12. Aufdampfsystem nach Anspruch 11, worin die ersten Mündungen (38) des ersten Gasverteilers (34) unter gleichförmigen Abständen um die Mitte des Substrats (20) herum angeordnet sind.

13. Aufdampfsystem nach Anspruch 11 oder 12, worin der erste Gasverteiler (34) einen ersten und einen zweiten Satz von Düsen (34, 34a) aufweist, wobei der erste Satz der Düsen strömungsmäßig von dem zweiten Satz der Düsen isoliert ist.

14. Aufdampfsystem nach Anspruch 11, worin die zentrale Düse (56) eine Vielzahl von zweiten Öffnungen (64) aufweist, und der dritte Gasverteiler (70) eine Vielzahl von dritten Mündungen (82) aufweist, die an nach außen versetzten Positionen an der Position in der Mitte des Oberteils (75) angeordnet sind, welche Position unter Abstand von und mittig oberhalb des Substrats (20) liegt.

15. Aufdampfsystem nach Anspruch 11, worin das Gehäuse (4) ein Oberteil aufweist, wobei das Oberteil eine Zugangsöffnung (74) durch es hindurch definiert; wobei die zentrale Düse (56) durch die Zugangsmündung (74) hindurch tritt, und wobei der dritte Gasverteiler (70) einen Durchgang (76) aufweist, der in einem Teil einer Strömungsmitteldichtung (78) definiert ist, welches zwischen einem Körper (70) und dem Oberteil (75) eingesetzt ist, und die Zutrittsöffnung (74) umgibt.

16. Aufdampfsystem nach Anspruch 15, worin der Durchgang eine Vielzahl von nach außen und unten verlaufenden Wegabschnitten (84) aufweist, die von der Düse (56) unter Abstand sind und zusätzliche Mündungen (82) des dritten Gasverteilers (70) bilden.

17. Aufdampfsystem nach Anspruch 11, worin das Gehäuse (4) eine dielektrische Kammer aufweist, wobei die dielektrische Kammer ein Oberteil (75) aufweist, und worin induktive Spulen (8) an dem Gehäuse (4) montiert und mit einem Hochfrequenzgenerator (10, 11) gekoppelt sind.

## Revendications

1. Procédé pour déposer un film sur un substrat (20) dans une chambre de dépôt (2) comportant un boîtier avec un dessus (75); le procédé comprenant les étapes suivantes:
- injection d'au moins un gaz de procédé dans la chambre (2) à plusieurs endroits (34) entourant un substrat (20) dans la chambre;
- injection d'un deuxième gaz de procédé dans la chambre (2) à partir d'une buse centrale à un endroit situé au centre du dessus (75); lequel endroit est éloigné du substrat et se trouve de manière centrale au dessus du substrat; et
- injection d'un troisième gaz de procédé dans la chambre (2) à partir d'un orifice annulaire entourant la buse centrale à un endroit au centre du dessus (75); lequel endroit est éloigné du substrat et se trouve de manière centrale au dessus du substrat,
- dans lequel procédé, la troisième étape d'injection d'un gaz de procédé est effectuée de manière à ce que le ledit troisième gaz de procédé et ledit deuxième gaz de procédé ne se mélangent pas avant d'avoir atteint l'intérieur de ladite chambre et dans lequel procédé, ledit deuxième gaz de procédé ou troisième gaz de procédé comprend du silane et ledit troisième gaz de procédé ou ledit deuxième gaz de procédé comprend respectivement un gaz qui apporte de l'oxygène.

2. Procédé selon la revendication 1, dans lequel la première étape d'injection de gaz de procédé est effectuée en utilisant un gaz qui apporte de l'oxygène, de préférence de l'oxygène , en tant que premier gaz de procédé et un gaz qui apporte du fluor en tant que gaz de procédé supplémentaire.

3. Procédé selon la revendication 1, dans lequel la première étape d'injection de gaz de procédé est effectuée en injectant au moins du silane en tant que premier gaz de procédé séparément dudit gaz qui apporte de l'oxygène en tant que gaz de procédé supplémentaire.

4. Procédé selon la revendication 1, dans lequel la deuxième étape d'injection de gaz de procédé est effectuée en injectant au moins du silane.

5. Procédé selon la revendication 1, dans lequel la première et deuxième étape d'injection de gaz de procédé sont effectuées en utilisant un gaz qui apporte du fluor et du silane.

6. Procédé selon la revendication 1, dans lequel la première et deuxième étape d'injection de gaz de procédé sont effectuées en utilisant des gaz de différents compositions.

7. Procédé selon la revendication 1, dans lequel la troisième étape d'injection de gaz de procédé est effectuée en utilisant un gaz qui apporte de l'oxygène, de préférence de l'oxygène.

8. Procédé selon la revendication 1, dans lequel la deuxième étape d'injection de gaz de procédé est effectuée en utilisant au moins du silane et du tetrafluorure de silicium , et dans lequel les débits de tetrafluorure de silicium et de silane sont choisis, respectivement, à environ 36 et 44 sccm; un débit total d'au moins 80 sccm étant choisi pour l'oxygène.

9. Procédé selon la revendication 5, dans lequel un diagramme été créé en dessinant la constante diélectrique vers le débit d'un gaz qui apporte de l'oxygène pour chaque série de débit de silane et un gaz qui apporte du fluor , et dans lequel procédé la série souhaitée de débits est sélectionnée selon la constante diélectrique minimale desdits diagrammes.

10. Procédé selon l'une quelconque des revendications 1 à 9, dans lequel les trois étapes d'injection ont lieu simultanément.

11. Système de dépôt pour effectuer un procédé selon l'une quelconque des revendications 1 à 10, comprenant :
- un boîtier (4) ayant un dessus (75) délimitant une chambre (2);
- un support de substrat (14) à l'intérieur de la chambre (2);
- premier distributeur de gaz (34) ayant des premiers orifices (34) s'ouvrant vers la chambre (2) à des endroits situés autour d'une surface de support de substrat (16);
- deuxième distributeur de gaz (56) comprenant une buse centrale (56) située à un endroit au centre du dessus (75); lequel endroit est éloigné du substrat et est situé de manière centrale au dessus du substrat (20); et
- un troisième distributeur de gaz (70) comprenant un orifice annulaire (76) entourant ladite buse centrale (56), lequel orifice est situé à un endroit au centre du dessus (75); lequel endroit est éloigné du substrat et situé de manière centrale au dessus du substrat (20);
- dans lequel procédé les premiers, deuxièmes et troisièmes distributeurs de gaz de procédé (34, 56, 70) sont connectés à des premiers, deuxièmes et troisièmes sources de gaz de procédé (35, 58, 71) séparées l'une de l'autre.

12. Système de dépôt selon la revendication 11, dans lequel des premiers orifices (38) du premier distributeur de gaz (34) sont éloignés de manière identique au dessus du centre du substrat (20).

13. Système de dépôt selon le revendication 11 ou 12, dans lequel ledit premier distributeur de gaz (34) comprend des premiers et deuxièmes séries de buses (34, 34a); ladite première série de buses est séparée de manière flexible de ladite deuxième série de buses.

14. Système de dépôt selon la revendication 11, dans lequel la buse centrale (56) comprend une pluralité de deuxièmes orifices (64) et le troisième distributeur de gaz (70) comprend une pluralité de troisièmes orifices (82) qui sont situés à des endroits dispersés au niveau de l'endroit au centre du dessus (75), lequel endroit est éloigné du substrat et situé de manière centrale au dessus du substrat (20).

15. Système de dépôt selon la revendication 11, dans lequel ledit boîtier (4) comprend un dessus; ledit dessus délimitant une ouverture d'accès (74) à travers le dessus; ladite buse centrale (56) passant à travers ladite ouverture d'accès (74); et le troisième distributeur de gaz (70) comprenant un chemin de passage (76) délimité en partie par un joint flexible (78) situé entre un corps (70), et ledit dessus (78) entourant ladite ouverture d'accès (74).

16. Système de dépôt selon la revendication 15, dans lequel ledit chemin de passage comprend une pluralité de parties de chemin s'étendant vers l'extérieure et vers le bas; lesquelles parties sont éloignées de ladite buse (56) et délimitent des orifices supplémentaires (82) du troisième distributeur de gaz (70).

17. Système de dépôt selon la revendication 11, dans lequel ledit boîtier (4) comprend une enceinte diélectrique; ladite enceinte diélectrique comprenant ledit dessus (75) et dans lequel système des bobines inductives (8) sont montées dans le boîtier (4) et couplées à un générateur de radiofréquence (10, 11).
